# EUROPEAN PATENT APPLICATION

(11) **EP 4 704 525 A1**
(43) Date of publication of application: **04.03.2026**
(21) Application number: 25179690.0
(22) Date of filing: 29.05.2025
(51) Int. Cl.: H10F 39/00

(54) **IMAGE SENSOR**

(30) Priority: 28.08.2024 KR 20240115704
(71) Applicant: Samsung Electronics Co., Ltd., Suwon-si, Gyeonggi-do 16677 (KR)
(72) Inventor: JIN, Younggu, 16677 Suwon-si (KR)
(74) Representative: Marks & Clerk LLP

(57) **Abstract**

An example image sensor includes a first layer having a plurality of pixels, and a second layer having a peripheral circuit. The peripheral circuit connects to the plurality of pixels through a plurality of row lines and a plurality of column lines to drive the plurality of pixels. The second layer is stacked on the first layer. Each of the plurality of pixels includes a photodiode, a floating diffusion region in which charge generated by the photodiode is stored, a transfer transistor connected with a space between the photodiode and the floating diffusion region, and an amplification transistor connected with the floating diffusion region. The first layer includes a first substrate, a first interlayer insulating layer on a surface of the first substrate, a semiconductor layer on a portion of the surface of the first substrate, and a first insulating layer.

## Description

### BACKGROUND

An image sensor may receive light and generate an electrical signal, and may include a pixel array having a plurality of pixels, and a peripheral circuit for driving the pixel array and generating an image. Each of the pixels may include a photodiode for generating charge, and a pixel circuit for converting the charge into an electrical signal. A rate at which the charge generated by the photodiode is converted into a voltage may be defined as a conversion gain. In a low-illumination environment, a small amount of charge may be generated by the photodiode due to a small amount of light that reaches the image sensor. In this case, it may be desired to convert a small amount of charge into a high voltage by increasing the conversion gain. Various methods have been proposed to increase the conversion gain.

### SUMMARY

The present disclosure relates to a method of increasing a conversion gain by omitting a metal interconnection, connecting a floating diffusion region and an amplification transistor to each other.

In some implementations, an image sensor includes a first layer on which a plurality of pixels are formed, and a second layer on which a peripheral circuit, connected to the plurality of pixels through a plurality of row lines and a plurality of column lines to drive the plurality of pixels, is disposed, the second layer stacked on the first layer in a first direction. Each of the plurality of pixels may include a photodiode, a floating diffusion region in which charge generated by the photodiode is stored, a transfer transistor connected to a space between the photodiode and the floating diffusion region, and an amplification transistor connected to the floating diffusion region. The first layer may include a first substrate, a first interlayer insulating layer formed on one surface of the first substrate, a semiconductor layer formed on a portion of the one surface of the first substrate, and a first insulating layer formed between the first substrate and the semiconductor layer. A source region, a drain region, and a channel region of the amplification transistor may be formed in the semiconductor layer. The channel region of the amplification transistor may be formed in a portion of the semiconductor layer overlapping the floating diffusion region in the first direction.

In some implementations, an image sensor includes a first layer on which a plurality of pixels are formed, and a second layer on which a peripheral circuit, obtaining a pixel signal by driving the plurality of pixels, is disposed, the second layer being stacked on the first layer in a first direction. Each of the plurality of pixels may include a photodiode, a floating diffusion region in which charge generated by the photodiode is stored, a transfer transistor connected to a space between the photodiode and the floating diffusion region, an amplification transistor connected to the floating diffusion region, and a selection transistor connected to a space between the amplification transistor and a column line. The first layer may include a first substrate, a first interlayer insulating layer formed on one surface of the first substrate, a semiconductor layer formed on a portion of the one surface of the first substrate, and a first insulating layer formed between the first substrate and the semiconductor layer. A second direction in which a gate of the transfer transistor and the floating diffusion region are disposed may intersect a third direction in which the semiconductor layer extends. The second direction and the third direction may be parallel to an upper surface of the first substrate, and perpendicular to the first direction.

In some implementations, an image sensor includes a first layer on which a plurality of pixels are formed, and a second layer on which a peripheral circuit, obtaining a pixel signal by driving the plurality of pixels, is disposed, the second layer stacked on the first layer in a first direction. Each of the pixels may include a photodiode, a floating diffusion region in which charge generated by the photodiode is stored, a transfer transistor connected to a space between the photodiode and the floating diffusion region, a reset transistor connected to a space between the floating diffusion region and a first power node, an amplification transistor connected to a space between the floating diffusion region, and a selection transistor connected to a space between the amplification transistor and a column line. The first layer may include a first substrate, a first interlayer insulating layer formed on one surface of the first substrate, a semiconductor layer formed on a portion of the one surface of the first substrate, and a first insulating layer formed between the first substrate and the semiconductor layer. The photodiode, the floating diffusion region, an active region of the transfer transistor, and an active region of the reset transistor may be formed in the first substrate. A channel region of the amplification transistor may be formed in a portion of the semiconductor layer disposed on the floating diffusion region, and a gate of the amplification transistor may be formed as the floating diffusion region. A gate of the transfer transistor may be a vertical transfer gate, and the photodiode may be disposed below the floating diffusion region in the first direction.

At least some of the above and other features of the invention are set out in the following claims.

### BRIEF DESCRIPTION OF THE DRAWINGS

The above and other aspects, features, and advantages of the present disclosure will be more clearly understood from the following detailed description, taken in conjunction with the accompanying drawings.
FIG. 1 is a schematic block diagram illustrating an example of an image sensor.
FIG. 2 is a schematic diagram illustrating an example of a pixel array structure of an image sensor.
FIG. 3 is a schematic diagram illustrating an example of a structure of a pixel included in an image sensor.
FIG. 4 is a circuit diagram illustrating an example of a pixel included in an image sensor.
FIG. 5 is a diagram illustrating an example of an operation of an image sensor.
FIG. 6 is a layout diagram illustrating an example of a pixel region.
FIG. 7 is a diagram illustrating an example of a portion of a cross-section of the pixel region illustrated in FIG. 6 in direction A-A'.
FIG. 8 is a diagram illustrating an example of a portion of a cross-section of the pixel region illustrated in FIG. 6 in direction B-B'.
FIG. 9 is a diagram illustrating an example of a portion of a cross-section of the pixel region illustrated in FIG. 6 in direction B-B'.
FIG. 10 is a layout diagram illustrating an example of a pixel region.
FIG. 11 is a diagram illustrating an example of a portion of a cross-section of the pixel region illustrated in FIG. 10 in direction A-A'.
FIG. 12 is a diagram illustrating an example of a portion of a cross-section of the pixel region illustrated in FIG. 10 in direction B-B'.
FIG. 13 is a layout diagram illustrating an example of a pixel region.
FIG. 14 is a diagram illustrating an example of a portion of a cross-section of the pixel region illustrated in FIG. 13 in direction A-A' of.
FIG. 15 is a diagram illustrating an example of a portion of a cross-section of the pixel region illustrated in FIG. 13 in direction B-B'.
FIG. 16 is a layout diagram illustrating an example of a pixel region.
FIG. 17 is a diagram illustrating an example of a portion of a cross-section of the pixel region illustrated in FIG. 16 in direction A-A'.
FIG. 18 is a diagram illustrating an example of a portion of a cross-section of the pixel region illustrated in FIG. 16 in direction B-B'.
FIG. 19 is a circuit diagram of an example of a pixel included in an image sensor.
FIG. 20 is a layout diagram illustrating an example of a pixel region.
FIG. 21 is a diagram illustrating an example of a portion of a cross-section of the pixel region illustrated in FIG. 20 in direction A-A'.
FIG. 22 is a diagram illustrating an example of a portion of a cross-section of the pixel region illustrated in FIG. 20 in direction B-B'.
FIG. 23 is a circuit diagram of an example of a pixel included in an image sensor.
FIG. 24 is a layout diagram illustrating an example of a pixel region.
FIG. 25 is a diagram illustrating an example of a portion of a cross-section of the pixel region illustrated in FIG. 24 in direction A-A'.
FIG. 26 is a diagram illustrating an example of a portion of a cross-section of the pixel region illustrated in FIG. 24 in direction B-B'.

### DETAILED DESCRIPTION

Hereinafter, example implementations of the present disclosure will be described with reference to the accompanying drawings as follows.

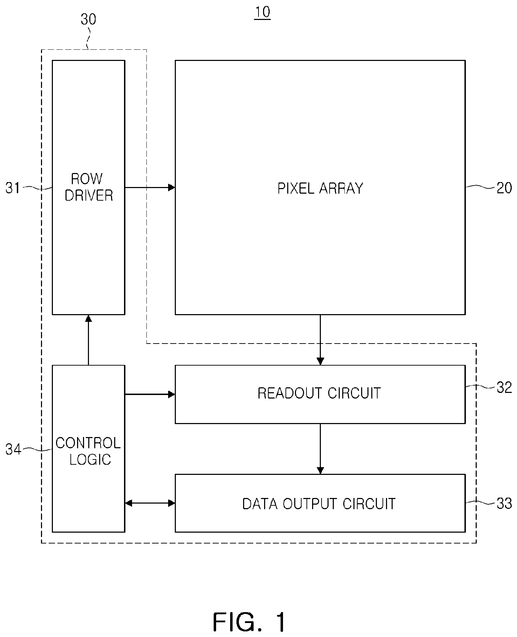

FIG. 1 is a schematic block diagram illustrating an example of an image sensor.

Referring to FIG. 1, an image sensor 10 may include a pixel array 20, a peripheral circuit 30, and the like.

The pixel array 20 may include a plurality of pixel regions arranged in an array form along a plurality of rows and a plurality of columns. A photoelectric conversion device, generating charge in response to light, may be disposed in each of the plurality of pixel regions, and the photoelectric conversion device may be connected to a pixel circuit, generating and outputting a signal corresponding to the charge generated by the photoelectric conversion device. A pixel may be implemented by the photoelectric conversion device and the pixel circuit. The photoelectric conversion device may include a photodiode formed of a semiconductor material, and/or an organic photodiode formed of an organic material.

For example, the pixel circuit may include a plurality of transistors. A capacitor may store an excessive amount of charge generated by the photodiode, and may be connected to the photodiode through at least one transistor. For another example, the pixel circuit may further include a capacitor. The capacitor may be a metal-insulator-metal (MIM) capacitor, a metal-oxide-semiconductor (MOS) capacitor, or a lateral over-flow integration capacitor (LOFIC).

The peripheral circuit 30 may include circuits for controlling the pixel array 20. For example, the peripheral circuit 30 may include a row driver 31, a readout circuit 32, a data output circuit 33, a control logic 34, and the like. The row driver 31 may drive the pixel array 20 in units of row lines. For example, the row driver 31 may input control signals for controlling ON/OFF of transistors, included in the pixel circuit, to the pixel array 20 in units of row lines.

Among pixels, pixels disposed at the same position in a row direction (a horizontal direction of FIG. 1) may share the same column line. For example, pixels disposed at the same position in a column direction (a vertical direction of FIG. 1) may be simultaneously selected by the row driver 31, and may output pixel signals through column lines. In some implementations, the readout circuit 32 may simultaneously receive signals from pixels, selected by the row driver 31, through the column lines. For example, the readout circuit 32 may sequentially receive a reset voltage and a signal voltage from each of the pixels, and the signal voltage may be a voltage in which charge, generated by a photodiode of each of the pixels, are reflected in the reset voltage.

The readout circuit 32 may include a plurality of correlated double samplers and a plurality of counters, and the correlated double samplers may be connected to the pixels through the column lines. For example, one correlated double sampler and one counter may be connected to one column line. The correlated double samplers may read voltage signals, through the column lines, from pixels connected to a row line selected by a row line selection signal of the row driver 31. One input terminal, among input terminals of each of the correlated double samplers, may be connected to the column lines, and the other input terminal may receive a ramp voltage.

An output terminal of each of the correlated double samplers may be connected to the counters, and the counters may generate a digital pixel signal by counting a time during which an output of each of the correlated double samplers is maintained at a specific voltage. For example, a counter may count a time during which a ramp voltage input to a correlated double sampler is higher than a voltage of a column line to convert an output of the correlated double sampler into a digital pixel signal. The data output circuit 33 may include a memory, such as a latch, a buffer circuit, or the like, temporarily storing a digital pixel signal.

The control logic 34 may include a timing controller for controlling operation timings of the row driver 31, the readout circuit 32, and the data output circuit 33. In some example implementations, the control logic 34 may determine a data format to be output by the data output circuit 33, or may preprocess data to be output by the data output circuit 33.

In a general image sensor, an amplification transistor may have a gate connected to a floating diffusion region, and the floating diffusion region and the gate of the amplification transistor may be connected to each other by metal interconnections. In this case, parasitic capacitance may occur between adjacent metal interconnections, leading to capacitive coupling between the metal interconnections. Accordingly, there may be a limitation in increasing a conversion gain. For example, a general conversion gain may be in a range from 150 µV/e to 200 µV/e.

In the image sensor 10, a metal interconnection, connecting a floating diffusion region and an amplification transistor to each other, may be omitted. An active region of the amplification transistor may be formed in a portion of a semiconductor layer disposed on the floating diffusion region. In other words, a gate of the amplification transistor may be formed as the floating diffusion region.

Accordingly, capacitive coupling between the metal interconnections may be removed to increase a conversion gain. The image sensor 10 may have a conversion gain of 200 µV/e or more, for example, a conversion gain of 500 µV/e. A small amount of charge may be converted into a high voltage even under a high conversion gain condition, a low-illumination environment, thereby improving sensitivity of the image sensor.

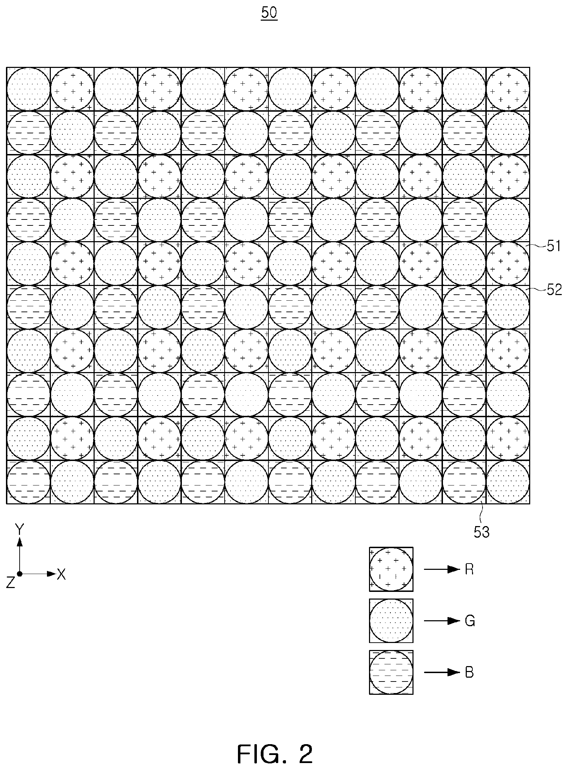

FIG. 2 is a schematic diagram illustrating an example of a pixel array structure of an image sensor.

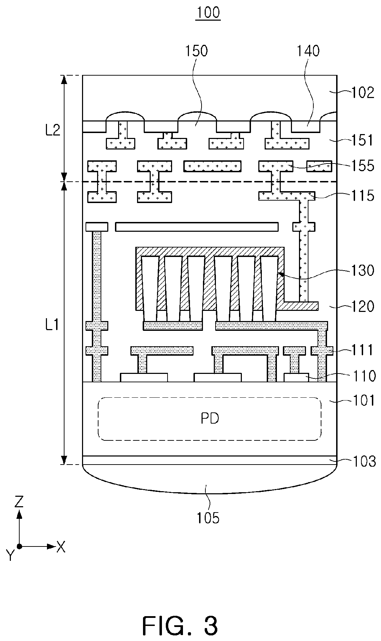

Referring to FIG. 2, a pixel array 50 of the image sensor may include a plurality of pixels 51 to 53, arranged in a second direction (X-axis direction) and a third direction (Y-axis direction). The second direction and third direction may be parallel to an upper surface of substrate (e.g. the first substrate 101 of FIG. 3) of the image sensor. The second direction and third direction may cross each other (e.g. may be perpendicular to each other). For example, the pixel array 50 may include red pixels 51, green pixels 52, and blue pixels 53. Each of the red pixels 51 may include a red color filter, each of the green pixels 52 may include a green color filter, and each of the blue pixels 53 may include a blue color filter. In the example implementation illustrated in FIG. 2, each of the green pixels 52 may be adjacent to some red pixels 51, among the red pixels 51, and some blue pixels 53, among the blue pixels 53, in the first direction and the second direction.

Each of the plurality of pixels 51 to 53 may include one photodiode. In some implementations, through a design of a pixel circuit connected to a photodiode in each of the plurality of pixels 51 to 53, a conversion gain in a low-illumination environment may be increased, thereby improving sensitivity of the image sensor.

FIG. 3 is a schematic diagram illustrating an example of a structure of a pixel included in an image sensor.

Referring to FIG. 3, an image sensor 100 may include a first layer L1 and a second layer L2. The first layer L1 and the second layer L2 may be stacked in a first direction (Z-axis direction). The first layer L1 may include a first substrate 101, and a photodiode PD and a plurality of transistors 110 may be formed in the first substrate 101. The plurality of transistors 110 may be connected to each other by metal interconnections 111 to provide a pixel circuit connected to the photodiode PD. The first direction may be perpendicular to an upper surface of the first substrate 101. The first direction may define a vertical direction of the image sensor 100. Features that are described as "above" other features may be located further along the first direction than the other features. Similarly, "upper" portions of certain features may be located further along the first direction than "lower" portions of the features. It will be appreciated that the directions described herein are relative to the structure of the image sensor 100, and therefore need not imply any particular orientation of the image sensor 100 during use.

Incident light may be incident on a first surface of the first layer L1. For example, incident light may be incident in the first direction from the outside of the image sensor 100. One surface (e.g. a second surface opposite the first surface) of the first substrate 101 may be used to dispose the plurality of transistors 110 for processing an electrical signal generated from the photodiode PD.

The metal interconnections 111 may be disposed in a first interlayer insulating layer 120 formed on the one (e.g. second) surface of the first substrate 101. An uppermost interconnection 115, disposed on an uppermost end of the first interlayer insulating layer 120, may be connected to an uppermost interconnection 155 of the second layer L2. A color filter 103 and a microlens 105 may be disposed on the other surface (e.g. the first surface) of the first substrate 101.

In the example implementation illustrated in FIG. 3, a capacitor 130 may be connected to the plurality of transistors 110 to be included in the pixel circuit. The capacitor 130 may be an MIM capacitor, but a type of the capacitor 130 may not be limited thereto. In addition, unlike FIG. 3, the pixel circuit may not include the capacitor 130.

The second layer L2 may include a second substrate 102, and a plurality of transistors 140 may be formed in the second substrate 102. The plurality of transistors 140 may be connected to each other by metal interconnections 155 disposed in the second interlayer insulating layer 151 to provide a peripheral circuit, driving a pixel array, for example, a row driver, a readout circuit, or the like. An uppermost interconnection 155, disposed on an uppermost end of the second interlayer insulating layer 151, may be connected to the uppermost interconnection 115 of the first layer L1.

In some implementations, the first layer L1 may further include a semiconductor layer formed on a portion of the one surface (e.g. the second surface) of the first substrate 101, and a first insulating layer formed between the first substrate 101 and the semiconductor layer. The semiconductor layer may be formed of an amorphous oxide semiconductor, a 2D nanomaterial, amorphous silicon, or polysilicon. A 2D nanomaterial may be a material having a thickness of 100 nm or less. The semiconductor layer may be formed by depositing the material as a thin film on the first substrate 101.

The first insulating layer may be a gate oxide (Gox) insulating layer disposed between a gate and a channel region of each of the plurality of transistors 110. For example, the first insulating layer may be formed of silicon oxide (SiO₂), a high-κ material, or the like. A high-κ material may be a material having a dielectric constant higher than that of silicon oxide.

Active regions of some transistors, among the plurality of transistors 110, may be formed in a semiconductor layer. Some transistors, among the plurality of transistors 110, may include an amplification transistor. An active region of the amplification transistor may be formed in the semiconductor layer, and a gate of the amplification transistor may be formed as a floating diffusion region. Accordingly, a conversion gain of the image sensor 100 may be increased by removing capacitive coupling between metal interconnections.

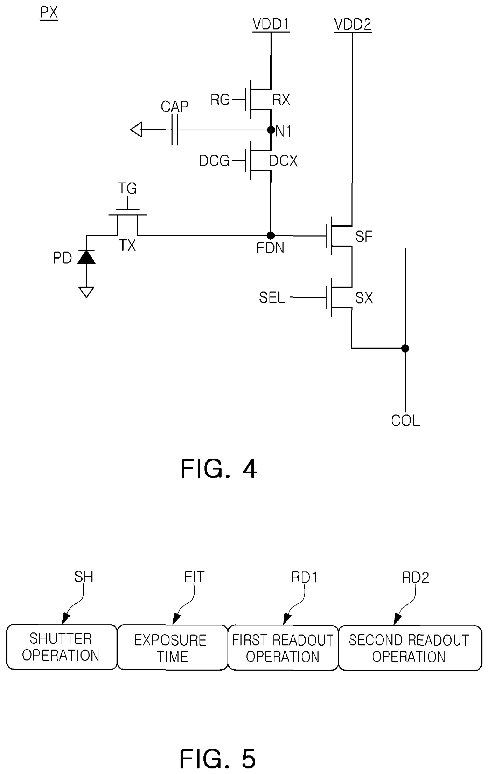

FIG. 4 is a circuit diagram illustrating an example of a pixel included in an image sensor.

Referring to FIG. 4, a pixel PX may include a photodiode PD and a pixel circuit. The pixel circuit may include a floating diffusion node FDN, a transfer transistor TX, a gain control transistor DCX, a capacitor CAP, a reset transistor RX, an amplification transistor SF, and a selection transistor SX. Each of a plurality of transistors, included in the pixel circuit, may include gates TG, RG, DRG, and SEL. Control signals for controlling the plurality of transistors included in the pixel circuit may be output by a row driver.

The floating diffusion node FDN may be connected to the photodiode PD through the transfer transistor TX. When the transfer transistor TX is turned on by a transfer control signal, charge of the photodiode PD may be stored in the floating diffusion node FDN. The gain control transistor DCX may be connected to a space between the floating diffusion node FDN and a first node N1. For instance, the gain control transistor DCX may be connected between the floating diffusion node FDN and a first node N1. The capacitor CAP may be connected to the first node N1.

When the gain control transistor DCX is turned on by a gain control signal, the capacitor CAP may be connected to the floating diffusion node FDN. Accordingly, capacitance of the floating diffusion node FDN may increase, such that a conversion gain of the pixel PX may decrease. Conversely, when the gain control transistor DCX is turned off by the gain control signal, the conversion gain of the pixel PX may increase.

The reset transistor RX may be connected to a space between a first power node and the first node N1. For instance, the reset transistor RX may be connected between a first power node and the first node N1. The first power node may be a node, supplying a first power voltage VDD1, and may be connected to a drain of the reset transistor RX. For instance, the first power node may be configured to receive the first power voltage VDD1 (e.g. from a power source).

The amplification transistor SF may be connected to the floating diffusion node FDN, and the amplification transistor SF may be connected to a space between a second power node and the selection transistor SX. For instance, the amplification transistor SF may be connected between a second power node and the selection transistor SX. The second power node may be a node, supplying a second power voltage VDD2. For instance, the second power node may be configured to receive the second power voltage VDD2 (e.g. from a power source). In some example implementations, the first power voltage VDD1 may be equal to or different from the second power voltage VDD2.

The amplification transistor SF may operate as a source-follower amplifier, and may generate a signal by amplifying a voltage of the floating diffusion node FDN. The signal, generated by the amplification transistor SF, may be output to a column line COL by a turn-on operation of the selection transistor SX. The column line COL may be connected to one of input terminals of a correlated double sampler, and the correlated double sampler may transmit, to a counter, a signal, output to the column line COL, and an output signal, determined by a ramp voltage.

In some implementations, a source region, a drain region, and a channel region of the amplification transistor SF may be formed in a semiconductor layer. The channel region of the amplification transistor SF may be formed in a portion of the semiconductor layer disposed on a region in which the floating diffusion node FDN is formed. In other words, a metal interconnection between the floating diffusion node FDN and a gate of the amplification transistor SF may be omitted. Thus, the conversion gain when the gain control transistor DCX is turned off may be further increased.

FIG. 5 is a diagram illustrating an example of an operation of an image sensor.

FIG. 5 is a schematic diagram illustrating an operation of a pixel included in an image sensor. In some implementations, pixels included in a pixel array may be arranged in a row direction and a column direction, may be connected to a row driver in the row direction, and may be connected to a readout circuit in the column direction. The row driver may simultaneously drive the pixels arranged in the row direction, and thus an operation illustrated in FIG. 5 may be simultaneously performed in two or more pixels arranged in the row direction.

An operation of a pixel may include a shutter operation SH, an exposure time EIT, a first readout operation RD1, and a second readout operation RD2.

In the shutter operation SH, a reset operation of removing charges of a photodiode and a floating diffusion node may be performed. For example, in the shutter operation SH, a transfer transistor, a conversion gain transistor, and a reset transistor may be turned on. In the shutter operation SH, the photodiode, the floating diffusion node, and a capacitor may be electrically connected to a first power node. Charge of the photodiode, the floating diffusion node, and the capacitor may be removed by a first power voltage.

During the exposure time EIT, the photodiode may be exposed to light to generate charge. For example, during the exposure time EIT, all transistors may be turned off. The photodiode and the floating diffusion node may be electrically isolated from each other. Thus, the charge, generated by the photodiode, may not move to the floating diffusion node. The photodiode may generate charge in response to light, and the generated charge may remain in the photodiode.

The first readout operation RD1 may be a readout operation to be performed under a condition in which the pixel is set to have a high conversion gain. However, in some example implementations, before the first readout operation RD1 is performed, an operation of resetting the floating diffusion node may be performed after the exposure time EIT ends.

When the exposure time EIT ends, the row driver may turn on a selection transistor, and a reset voltage may be output through a column line connected to the readout circuit. When the reset voltage is output, the transfer transistor may be turned on, and the charge generated by the photodiode during the exposure time may move to the floating diffusion node. The amplification transistor may output, to the column line, a signal voltage obtained by amplifying a voltage of the floating diffusion node. The readout circuit, connected to the column line, may calculate a first pixel signal from a difference between the reset voltage and the signal voltage. The first pixel signal may be a signal for covering (e.g. sensing) a relatively low range of illumination.

A gain control transistor, connected to the floating diffusion node, may be maintained in a turn-off state, such that the pixel may have a high conversion gain while the first readout operation is performed. Accordingly, a sufficiently small amount of capacitance of the floating diffusion node may be maintained, and the pixel may have a high conversion gain.

The second readout operation RD2 may be a readout operation performed under a condition in which the pixel is set to have a low conversion gain. While the second readout operation RD2 is being performed, a gain control transistor DCX may be turned on, and the capacitor may be electrically connected to the floating diffusion node.

In a state in which the gain control transistor is turned on and the capacitance of the floating diffusion node increases, the transfer transistor may be turned on, such that the charge remaining in the photodiode may move to the floating diffusion node. In the second readout operation RD, a signal voltage may be output to the column line under the condition in which the pixel has a low conversion gain.

At least a portion of the charge of the photodiode may already move to the floating diffusion node in the first readout operation RD1, such that a reset voltage may not be output prior to the signal voltage in the second readout operation RD2. The transfer transistor, the reset transistor, and the gain control transistor may be turned on, such that the pixel may output a reset voltage through the column line. The readout circuit may calculate a second pixel signal under a low conversion gain condition, using a difference between the signal voltage obtained in the second readout operation RD2 and the reset voltage. The second pixel signal may be a signal for covering (e.g. sensing) a relatively high range of illuminance.

Unlike the example implementation illustrated in FIG. 5, a third readout operation may be additionally performed. The third readout operation may be an operation of reading a signal voltage corresponding to charge, generated by the photodiode and stored in the capacitor due to significantly high-intensity light, in an exposure operation.

In an environment in which light, introduced into the photodiode, has a significantly high intensity, charge may be generated in excess of a full well capacity (FWC) of the photodiode. In this case, a voltage of a node connected to a space between (e.g. connected between) the photodiode and the transfer transistor may decrease due to an excessive amount of charge generated by the photodiode, such that leakage may occur through the transfer transistor, and charge generated above the FWC of the photodiode may move to the capacitor due to overflow and be stored in the capacitor. In the third readout operation, in a state in which the gain control transistor is turned on and the charge stored in the capacitor move to the floating diffusion node, a signal voltage may be output to the column line.

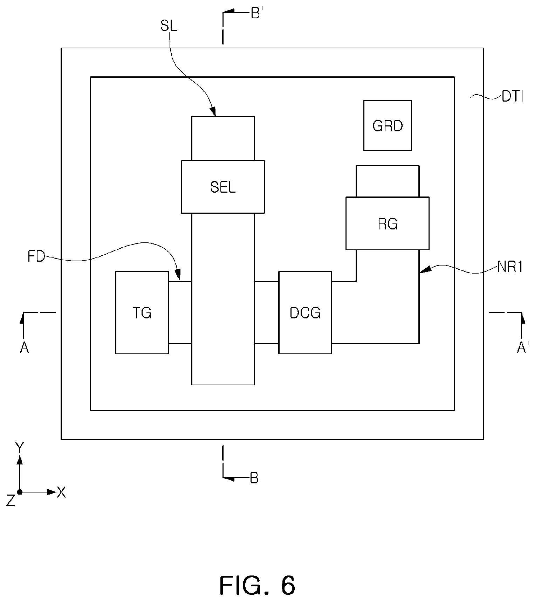

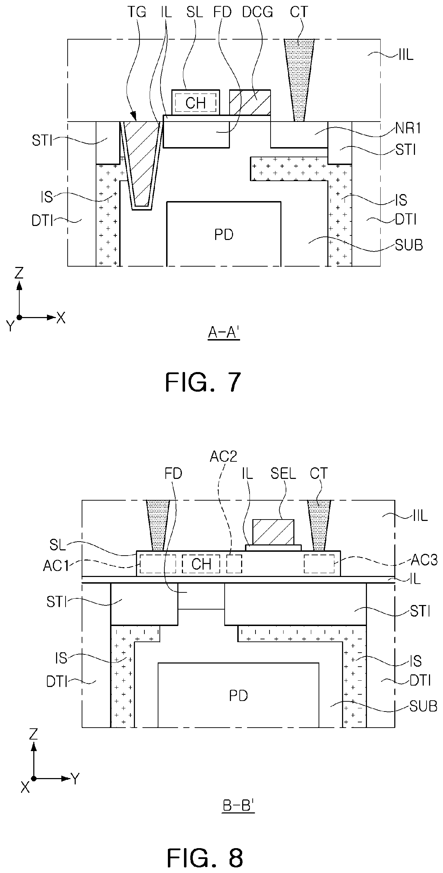

FIG. 6 is a layout diagram illustrating an example of a pixel region. FIG. 7 is a diagram illustrating an example of a portion of a cross-section of the pixel region illustrated in FIG. 6 in direction A-A'. FIG. 8 is a diagram illustrating an example of a portion of a cross-section of the pixel region illustrated in FIG. 6 in direction B-B'.

An image sensor may include a first layer on which a plurality of pixels are formed, and a second layer on which a peripheral circuit is disposed. The peripheral circuit may be connected to the plurality of pixels through a plurality of row lines and a plurality of column lines to drive the plurality of pixels. The first layer and the second layer may be stacked in a first direction (Z-axis direction). Specific example implementations of the image sensor may be similar to those described with reference to FIGS. 1 to 5.

The plurality of pixels may be isolated from each other by a deep trench isolation DTI. In the example implementation illustrated in FIG. 4, one pixel may be formed in a pixel region. FIGS. 6 to 8 may be diagrams illustrating the pixel PX according to the example implementation illustrated in FIG. 4. The deep trench isolation DTI may have a shape surrounding the pixel region, and the pixel region may have a rectangular shape. However, unlike that illustrated in FIG. 4, the plurality of pixels may be formed in the pixel region.

The deep trench isolation DTI may be formed of a plurality of materials. For example, the deep trench isolation DTI may be formed by combining silicon oxide (SIO) and polycrystalline silicon, or by combining silicon-oxide and metal. For another example, the deep trench isolation DTI may be formed by combining aluminum-oxide and silicon-oxide.

FIGS. 7 and 8 illustrate cross-sections of portions of a first layer of a pixel region illustrated in FIG. 6. The first layer may include a first substrate SUB, a first interlayer insulating layer IIL, a semiconductor layer SL, and a first insulating layer IL.

The first substrate SUB may be bulk silicon or a silicon-on-insulator (SOI). Alternatively, the first substrate SUB may be a silicon substrate, or may include silicon germanium, indium antimonide, a lead tellurite compound, indium arsenide, indium phosphide, gallium arsenide, or gallium antimonide. Alternatively, the substrate SUB may be a substrate having an epitaxial layer formed on a base substrate.

The first interlayer insulating layer IIL may be formed on one surface of the first substrate SUB, and the one surface of the first substrate SUB may be used to dispose a plurality of transistors for processing an electrical signal generated from a photodiode PD. For example, a transfer transistor, an amplification transistor, a selection transistor, a reset transistor, or the like may be formed on the one surface of the first substrate SUB. For another example, a gain conversion transistor may be additionally formed on the first substrate SUB.

The first interlayer insulating layer IIL may be formed on the one surface of the first substrate SUB. The first interlayer insulating layer IIL may include at least one of a low-κ material. A low-κ material may be a material having a dielectric constant lower than that of silicon oxide, silicon nitride, and silicon oxynitride.

The semiconductor layer SL may be formed on the one surface of the first substrate SUB. Specifically, the semiconductor layer SL may be formed on the first substrate SUB. In some implementations, an active region of the amplification transistor may be formed in the semiconductor layer SL. The semiconductor layer SL may be formed of an amorphous oxide semiconductor, a 2D nanomaterial, amorphous silicon, or polysilicon. The semiconductor layer SL may be formed by depositing the material as a film on the first substrate SUB.

The first insulating layer IL may be formed between a gate and a channel region of each of the plurality of transistors. The first insulating layer IL may be a Gox insulating layer. For example, the first insulating layer may be formed of silicon oxide or a high-κ material.

Referring to FIGS. 6 to 8, the pixel region may include a photodiode PD, a floating diffusion region FD, a transfer transistor, an amplification transistor, a selection transistor, and a reset transistor.

According to some implementations, the photodiode PD, the floating diffusion region FD, an active region of the transfer transistor, and an active region of the reset transistor may be formed in the first substrate SUB. For instance, the photodiode PD, the floating diffusion region FD, the active region of the transfer transistor, and the active region of the reset transistor may be formed in the first substrate SUB through doping. Accordingly, the floating diffusion region may be a doped portion of the first substrate SUB. In addition, a channel region of the amplification transistor may be formed in a portion of the semiconductor layer SL disposed on the floating diffusion region FD.

Referring to FIGS. 6 and 7, a gate TG of the transfer transistor and a floating diffusion region FD may be disposed in a second direction (X-axis direction), parallel to the upper surface of the first substrate SUB and perpendicular to the first direction. Referring to FIGS. 6 and 8, the semiconductor layer SL may extend in a third direction (Y-axis direction), parallel to the upper surface of the first substrate SUB and perpendicular to the first direction and the second direction. A second direction in which the gate TG of the transfer transistor and the floating diffusion region FD are disposed may intersect a third direction in which the semiconductor layer SL extends.

Referring to FIGS. 7 and 8, a shallow trench isolation layer STI may define an active region in a pixel region. The shallow trench isolation STI may be formed in the first substrate SUB to be adjacent to the one surface of the first substrate SUB. The shallow trench isolation STI may be formed by filling an insulating material in a trench formed by patterning the first substrate SUB. Accordingly, the shallow trench isolation STI may define a region in which the shallow trench isolation STI is not formed as the active region.

Referring to FIG. 7, the gate TG of the transfer transistor may be a vertical transfer gate. A vertical transfer gate may be a transfer gate TG that penetrates vertically into the first substrate SUB. A channel of the transfer transistor may run vertically, adjacent to the vertical transfer gate. For instance, the channel may be formed between the photodiode PD and the floating diffusion region (e.g. when the transfer transistor is turned on). The first insulating layer IL may be disposed between the gate TG of the transfer transistor and the first substrate SUB. In this case, the photodiode PD may be disposed below the floating diffusion region FD in the first direction (Z-axis direction). Alternatively, unlike that illustrated in FIGS. 7 and 8, the gate TG of the transfer transistor and the photodiode PD may be disposed on the one surface of the first substrate SUB in the second direction (X-axis direction).

An isolation region IS may be formed around the photodiode PD. The isolation region IS may be formed to be in contact with the deep trench isolation DTI and/or the shallow trench isolation STI. The isolation region IS and the photodiode PD may have different doping types. For example, the isolation region IS may be doped with a P-type, and the photodiode PD may be doped with an N-type. Accordingly, the isolation region IS may prevent charge generated by the photodiode PD from being dispersed in other regions, such that the charge generated in the photodiode PD may be stored in the floating diffusion region FD.

Referring to FIGS. 6 and 7, a first node region NR1 may be a region in which the first node N1 of FIG. 4 is formed. Referring to FIG. 6, the first node region NR1 may extend in the second direction and the third direction. A portion of the first node region NR1, extending in the second direction, may be disposed in the second direction, together with the gate TG of the transfer transistor and the floating diffusion region FD. A portion of the first node region NR1, extending in the third direction, may be disposed in the third direction, together with the active region of the reset transistor.

In some implementations, a source region AC1, a drain region AC2, and a channel region CH of the amplification transistor may be formed in the semiconductor layer SL. A source region AC1 of the amplification transistor and a second power node may be connected to each other through metal interconnections CT. The second power node may be a node, supplying a second power voltage.

In some implementations, a gate of the amplification transistor may be formed as the floating diffusion region FD. The channel region CH of the amplification transistor may be formed between the source region AC1 and the drain region AC2 of the amplification transistor. Specifically, the channel region CH of the amplification transistor may be formed in a portion of the semiconductor layer SL overlapping the floating diffusion region FD in the first direction (Z-axis direction).

In the example implementations illustrated in FIGS. 6 to 8, an active region of the selection transistor may also be formed in the semiconductor layer SL. A source region AC2 and a drain region AC3 of the selection transistor may be formed in the semiconductor layer SL. The drain region AC2 of the amplification transistor may form (or may be integrally formed with) the source region AC2 of the selection transistor. A gate SEL of the selection transistor may be formed on the semiconductor layer SL, and the first insulating layer IL may be disposed between the gate SEL of the selection transistor and the semiconductor layer SL.

The selection transistor may be connected to a space between the amplification transistor and the column line. For instance, the selection transistor may be connected between the amplification transistor and the column line. The drain region AC3 of the selection transistor and the column line may be connected through the metal interconnections CT. In this case, the selection transistor may output a reset voltage and/or a signal voltage to the column line.

A source region and a drain region of the reset transistor may be formed in the first substrate SUB, and a gate RG of the reset transistor may be formed on the first insulating layer IL. A structure of the reset transistor may be similar to a structure of a gain control transistor. The reset transistor may be connected to a space between the floating diffusion region FD and the first power node. For instance, the reset transistor may be connected between the floating diffusion region FD and the first power node. Specifically, the reset transistor may be connected to a space between the first node region NR1 and the first power node. For instance, the reset transistor may be connected between the first node region NR1 and the first power node. The source region of the reset transistor and the first power node may be connected through the metal interconnections CT. The first power node may be a node, supplying a first power voltage.

In the example implementations illustrated in FIGS. 6 to 8, the pixel may include a gain control transistor and a capacitor. The gain control transistor may be connected to a space between the floating diffusion region FD and the first node region NR1. For instance, the gain control transistor may be connected between the floating diffusion region FD and the first node region NR1. An active region of the gain control transistor may be formed in the first substrate SUB between the floating diffusion region FD and the first node region NR1.

A gate DCG of the gain control transistor may be disposed on the first substrate SUB, and the first insulating layer IL may be disposed between the gate DCG of the gain control transistor and the first substrate SUB. In other words, the gate DCG of the gain control transistor may be formed on the first insulating layer IL. For example, the gate DCG of the gain control transistor may be disposed to be adjacent to the semiconductor layer SL.

The capacitor may be formed on the first insulating layer IL, and a specific example implementation may be similar to that illustrated in FIG. 4. The first node region NR1 and the capacitor may be connected to each other through the metal interconnections CT.

Referring to FIG. 6, the pixel may include a ground region GRD. The ground region GRD may provide a reference potential to the pixel, and may be connected to several devices formed in the pixel. The photodiode PD and the capacitor may be connected to the ground region GRD through the metal interconnections, and charge may stably move due to the reference potential. In addition, the isolation region IS may be connected to the ground region GRD through the metal interconnections, and may stably prevent the charge generated by the photodiode PD from being dispersed by the reference potential.

In the example implementations illustrated in FIGS. 6 to 8, the active regions of the amplification transistor and the selection transistor may be formed in the semiconductor layer SL. The channel region CH of the amplification transistor may overlap the floating diffusion region FD in the first direction. Accordingly, a metal interconnection, connecting the floating diffusion region FD and the amplification transistor to each other, may be omitted, thereby increasing a conversion gain.

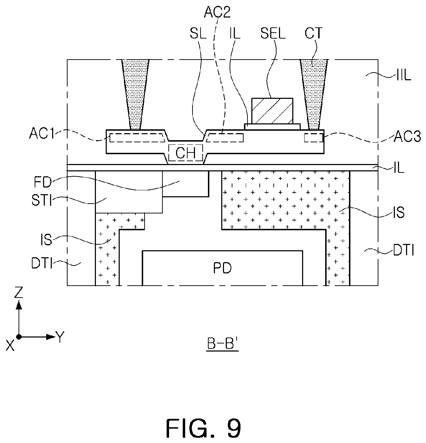

FIG. 9 is a diagram illustrating an example of a portion of a cross-section of the pixel region illustrated in FIG. 6 in direction B-B'.

The layout diagram of the pixel region according to FIG. 9 may be the same as that of FIG. 6, and a portion of the cross-section of the pixel region in the direction of A-A' according to FIG. 9 may be the same as that of FIG. 7. Specific example implementations of the pixel region illustrated in FIG. 9 may be similar to those described with reference to FIGS. 6 to 8, except for a shape of a semiconductor layer SL.

Comparing FIG. 9 with FIG. 8, a shape of a semiconductor layer SL of FIG. 9 may be different from a shape of a semiconductor layer SL of FIG. 8. A lower surface of the entire region of the semiconductor layer SL of FIG. 8 may be in contact with a first insulating layer IL. Alternatively, a lower surface of a portion of the semiconductor layer SL of FIG. 9 may be in contact with a first insulating layer IL, and a lower surface of a remaining portion of the semiconductor layer SL may be in contact with a first interlayer insulating layer IIL.

The portion of the semiconductor layer SL in contact with the first insulating layer IL may overlap a floating diffusion region FD in a first direction (Z-axis direction). In other words, a channel region CH of an amplification transistor may be formed in the portion of the semiconductor layer SL in contact with the first insulating layer IL. A gate of the amplification transistor may be formed as the floating diffusion region FD.

Source and/or drain regions AC1 to AC3, formed in the semiconductor layer SL, may be formed in a portion of an upper portion of the semiconductor layer SL as in the example implementation illustrated in FIG. 9. However, positions and/or shapes of the source and/or drain regions AC1 to AC3, formed in the semiconductor layer SL, may not be limited to the example implementation illustrated in FIG. 9.

A shallow trench isolation STI may be formed in a portion of a first substrate SUB overlapping the active region of the selection transistor of FIG. 8 in the first direction. Alternatively, an isolation region IS may be formed in a portion of a first substrate SUB overlapping an active region of a selection transistor of FIG. 9 in the first direction.

The lower surface of the remaining portion of the semiconductor layer SL in contact with the first interlayer insulating layer IIL of FIG. 9 may have a predetermined interval in the first direction from an upper surface of the first substrate SUB. Accordingly, the active region of the selection transistor of FIG. 9 may not be affected by a potential formed in the isolation region IS, such that the shallow trench isolation STI may be omitted.

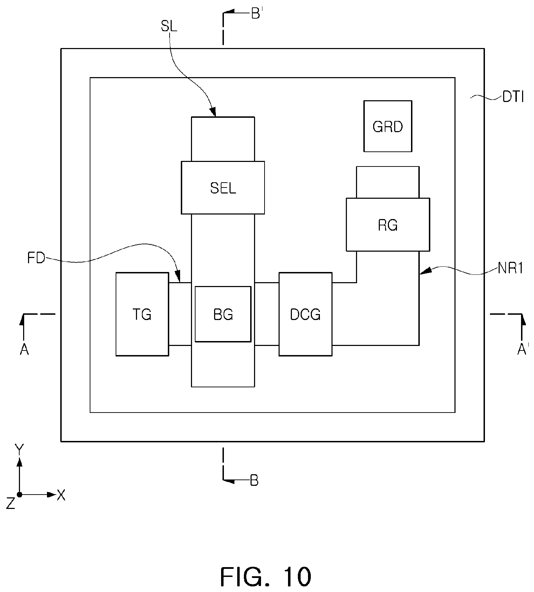

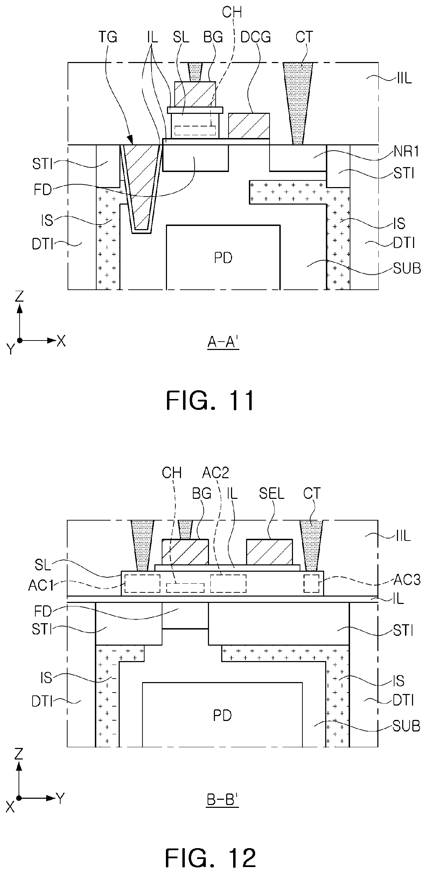

FIG. 10 is a layout diagram illustrating an example of a pixel region. FIG. 11 is a diagram illustrating an example of a portion of a cross-section of the pixel region illustrated in FIG. 10 in direction A-A'. FIG. 12 is a diagram illustrating an example of a portion of a cross-section of the pixel region illustrated in FIG. 10 in direction B-B'.

Comparing FIGS. 10 to 12 with FIGS. 6 to 8, the layout diagram of the pixel region according to the example implementations illustrated in FIGS. 10 to 12 may further include a back gate BG. Specific example implementations of the pixel region illustrated in FIGS. 10 to 12 may be similar to those described with reference to FIGS. 6 to 8, except for the back gate BG.

Referring to FIGS. 10 to 12, the pixel region may further include a back gate BG. The back gate may overlap a floating diffusion region FD and a portion of a semiconductor layer SL in a first direction (Z-axis direction). Specifically, a channel region CH of an amplification transistor may be included in the portion of the semiconductor layer SL.

A negative voltage may be applied to the back gate BG. Accordingly, the channel region CH of the amplification transistor may be formed to be limited only to the semiconductor layer SL close to the floating diffusion region FD in the first direction. Comparing FIGS. 11 and 12 with

FIGS. 8 and 9, a thickness of the channel region CH of the amplification transistor of FIGS. 11 and 12 may be less than that of the channel region CH of the amplification transistor of FIGS. 8 and 9.

As the thickness of the channel region CH of the amplification transistor according to some implementations of FIGS. 11 and 12 decreases, a voltage of the floating diffusion region FD may be further affected. In other words, reactivity of the channel region CH of the amplification transistor may be improved. Accordingly, a conversion gain may be further increased.

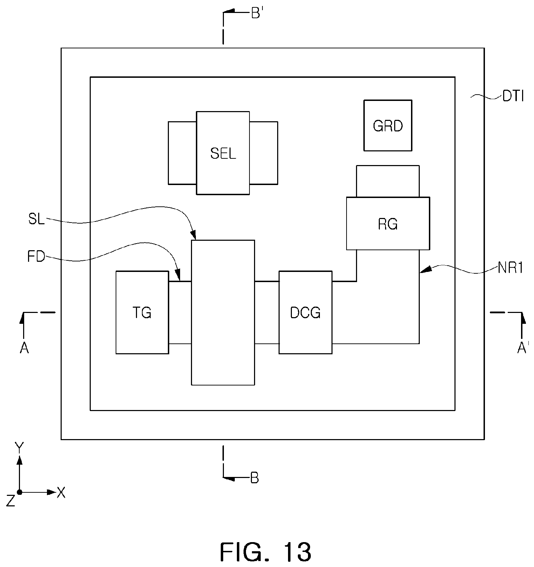

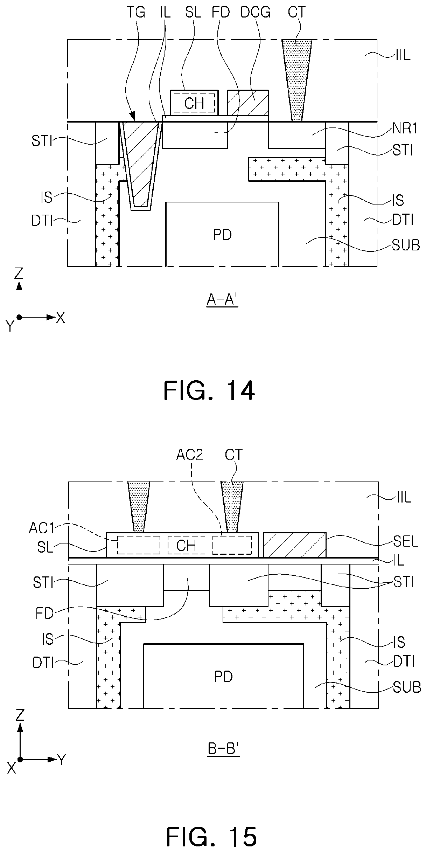

FIG. 13 is a layout diagram illustrating an example of a pixel region. FIG. 14 is a diagram illustrating an example of a portion of a cross-section of the pixel region illustrated in FIG. 13 in direction A-A' of. FIG. 15 is a diagram illustrating an example of a portion of a cross-section of the pixel region illustrated in FIG. 13 in direction B-B'.

Specific example implementations of the pixel region illustrated in FIGS. 13 to 15 may be similar to those described with reference to FIGS. 6 to 8, except for a region in which a selection transistor is formed. The cross-section of the pixel region in the direction of A-A' of FIG. 14 may be the same as that of FIG. 7.

Referring to FIGS. 13 to 15, a source region and a drain region of the selection transistor may be formed in a first substrate SUB, and a gate SEL of the selection transistor may be formed on a first insulating layer IL. Conversely, the source region and the drain region of the selection transistor according to some implementations of FIGS. 6 to 8 may be formed in a semiconductor layer SL.

Referring to FIG. 15, a channel region of a selection transistor may be formed in a portion of the first substrate SUB, overlapping the gate SEL of the selection transistor in a first direction (Z-axis direction). An isolation region IS may be disposed below the portion of the first substrate SUB. A channel region CH of an amplification transistor may be included in the portion of the semiconductor layer SL. The channel region CH of the amplification transistor may be formed to be limited only to the semiconductor layer SL close to a floating diffusion region FD in the first direction (Z-axis direction).

In some implementations, the selection transistor may be formed on the first substrate SUB instead of the semiconductor layer SL, thereby increasing usability of the first substrate SUB.

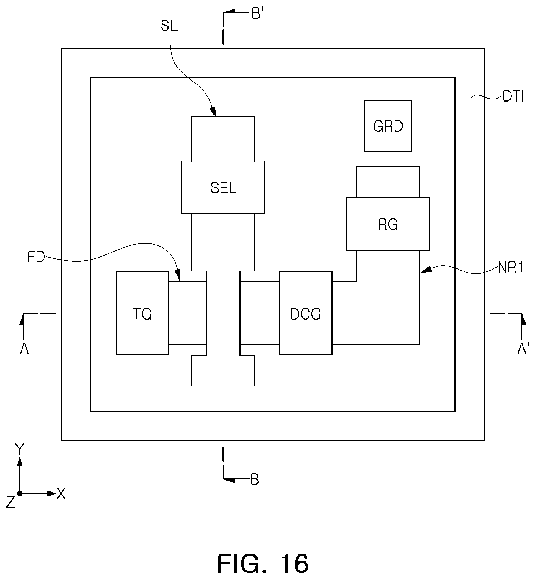

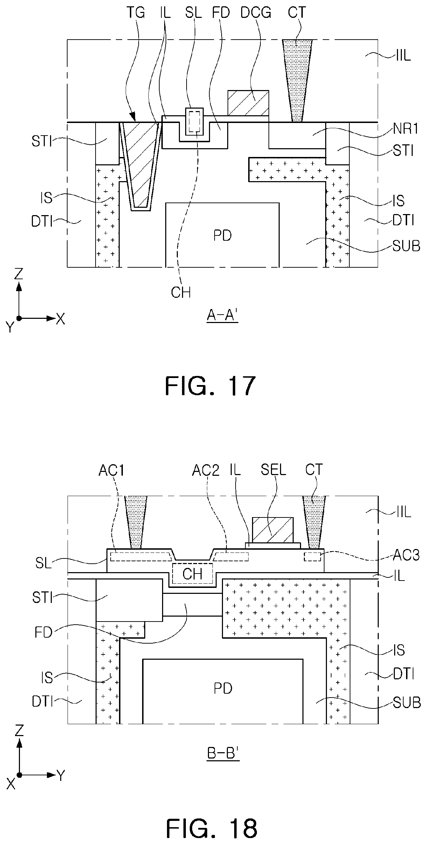

FIG. 16 is a layout diagram illustrating an example of a pixel region. FIG. 17 is a diagram illustrating an example of a portion of a cross-section of the pixel region illustrated in FIG. 16 in direction A-A'. FIG. 18 is a diagram illustrating an example of a portion of a cross-section of the pixel region illustrated in FIG. 16 in direction B-B'.

Specific example implementations of the pixel region illustrated in FIGS. 16 to 18 may be similar to those described with reference to FIGS. 6 to 8, except for a structure of a semiconductor layer.

Referring to FIGS. 16 to 18, a portion of a semiconductor layer SL may have a fin structure, and the portion of the semiconductor layer SL may be a region adjacent to a floating diffusion region FD. The floating diffusion region FD may have a shape surrounding the portion of the semiconductor layer SL, and a first insulating layer IL may be disposed between the semiconductor layer SL and the floating diffusion region FD.

In the example implementation illustrated in FIG. 18, source and/or drain regions AC1 to AC3, formed in the semiconductor layer SL, may be formed in a portion of an upper portion of the semiconductor layer SL. However, positions and/or shapes of the source and/or drain regions AC1 to AC3, formed in the semiconductor layer SL, may not be limited to the example implementation illustrated in FIG. 9.

Comparing FIGS. 16 to 18 with FIGS. 6 to 8, an area of the semiconductor layer SL of FIGS. 16 to 18 in contact with the floating diffusion region FD may increase. In other words, a contact area between a gate of an amplification transistor and a channel region CH of the amplification transistor may increase, thereby easily controlling movement of charge in the channel region CH of the amplification transistor.

Structures of the pixel regions according to the example implementations illustrated in FIGS. 6 to 18 may be applied in combination with each other.

For example, a back gate BG may be formed to overlap the channel region CH formed in the semiconductor layer SL in the first direction by combining the example implementations of FIGS. 10 to 12 with the example implementations of FIGS. 13 to 15. In this case, a gate SEL of a selection transistor may be formed on a first insulating layer IL disposed on the first substrate SUB.

For another example, a portion of the semiconductor layer SL in which the channel region CH of the amplification transistor is formed may have a fin structure by combining the example implementations of FIGS. 16 to 18 with the example implementation of FIG. 9. In this case, a lower surface of the remaining portion of the semiconductor layer SL may be in contact with the first interlayer insulating layer IIL.

However, types of combinations of the example implementations illustrated in FIGS. 6 to 18 may not be limited thereto.

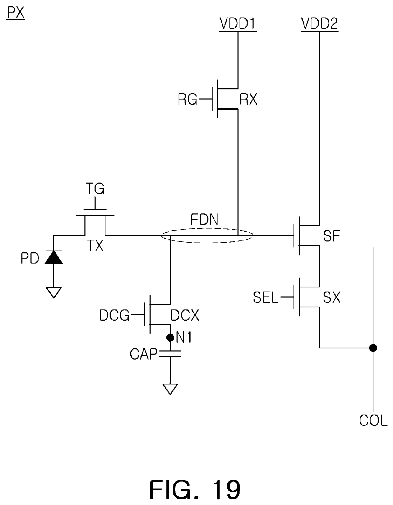

FIG. 19 is a circuit diagram of an example of a pixel included in an image sensor.

Referring to FIG. 19, a pixel PX may include a photodiode PD and a pixel circuit. The pixel circuit may include a floating diffusion node FDN, a transfer transistor TX, a gain control transistor DCX, a capacitor CAP, a reset transistor RX, an amplification transistor SF, and a selection transistor SX. A plurality of transistors TG, RG, DRG, RG, and SEL, included in the pixel circuit, may be included. Control signals for controlling the plurality of transistors included in the pixel circuit may be output by a row driver.

The floating diffusion node FDN may be connected to the photodiode PD through the transfer transistor TX. When the transfer transistor TX is turned on by a transfer control signal, charge of the photodiode PD may be stored in the floating diffusion node FDN.

In the example implementation illustrated in FIG. 19, the gain control transistor DCX may be connected to a space between the floating diffusion node FDN and a first node N1. For instance, the gain control transistor DCX may be connected between the floating diffusion node FDN and the first node N1. The capacitor CAP may be connected to the first node N1. The reset transistor RX may be connected to a space between a first power node and the floating diffusion node FDN. For instance, the reset transistor RX may be connected between the first power node and the floating diffusion node FDN. The first power node may be a node, supplying a first power voltage VDD1, and may be connected to a drain of the reset transistor RX.

Comparing FIG. 19 with FIG. 4, there may be a difference in terms of a connection structure between the gain control transistor DCX and the capacitor CAP. Specifically, the gain control transistor DCX and the capacitor CAP of FIG. 19 may not be connected to a space between (e.g. connected between) the reset transistor RX and the floating diffusion node FDN.

When the gain control transistor DCX is turned on by a gain control signal, the capacitor CAP may be connected to the floating diffusion node FDN. Accordingly, capacitance of the floating diffusion node FDN may increase, such that a conversion gain of the pixel PX may decrease. Conversely, when the gain control transistor DCX is turned off by the gain control signal, the conversion gain of the pixel PX may increase.

The amplification transistor SF may be connected to the floating diffusion node FDN, and the amplification transistor SF may be connected to a space between (e.g. connected between) a second power node and the selection transistor SX. The second power node may be a node, supplying a second power voltage VDD2. In some example implementations, the first power voltage VDD1 may be equal to or different from the second power voltage VDD2.

The amplification transistor SF may operate as a source-follower amplifier, and may generate a signal by amplifying a voltage of the floating diffusion node FDN. The signal, generated by the amplification transistor SF, may be output to a column line COL by a turn-on operation of the selection transistor SX. The column line COL may be connected to one of input terminals of a correlated double sampler, and the correlated double sampler may transmit, to a counter, a signal, output to the column line COL, and an output signal, determined by a ramp voltage.

In some implementations, a source region, a drain region, and a channel region of the amplification transistor SF may be formed in a semiconductor layer. The channel region of the amplification transistor SF may be formed in a portion of the semiconductor layer, disposed on a region in which the floating diffusion node FDN is formed. In other words, a metal interconnection between the floating diffusion node FDN and a gate of the amplification transistor SF may be omitted. Thus, the conversion gain when the gain control transistor DCX is turned off may be further increased.

An operation of the image sensor including the pixel PX of FIG. 19 may be similar to that described above with reference to FIG. 5.

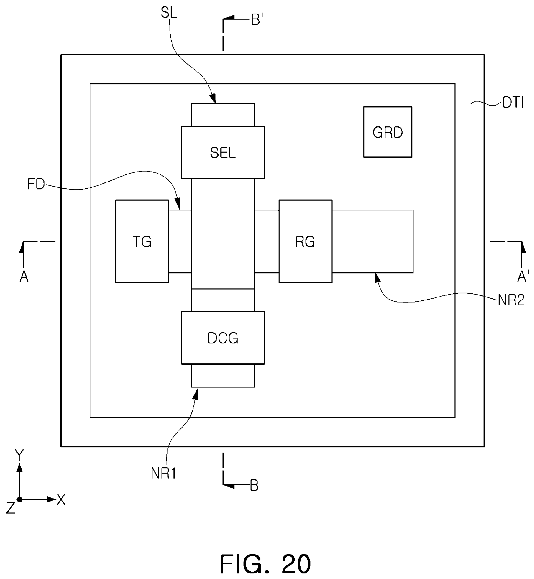

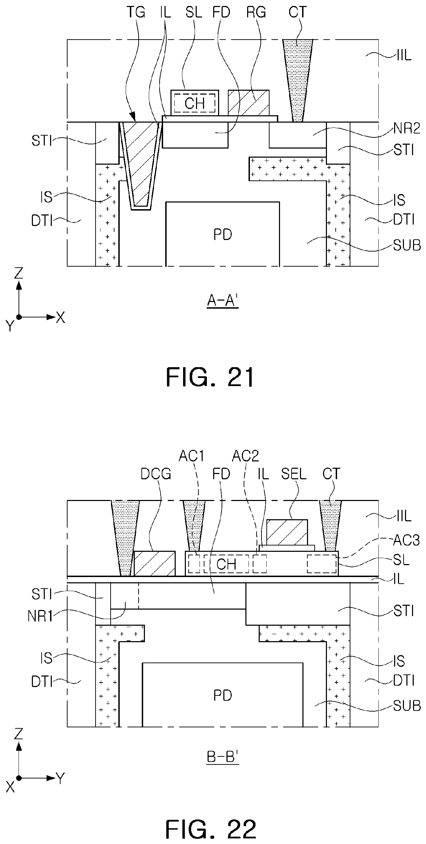

FIG. 20 is a layout diagram illustrating an example of a pixel region. FIG. 21 is a diagram illustrating an example of a portion of a cross-section of the pixel region illustrated in FIG. 20 in direction A-A'. FIG. 22 is a diagram illustrating an example of a portion of a cross-section of the pixel region illustrated in FIG. 20 in direction B-B'.

An image sensor may include a first layer on which a plurality of pixels are formed, and a second layer on which a peripheral circuit is disposed. The peripheral circuit may be connected to the plurality of pixels through a plurality of row lines and a plurality of column lines to drive the plurality of pixels. The first layer and the second layer may be stacked in a first direction (Z-axis direction). Specific example implementations of the image sensor may be similar to those described with reference to FIGS. 1 to 3.

The plurality of pixels may be isolated from each other through a deep trench isolation DTI. In the example implementation illustrated in FIG. 20, one pixel may be formed in a pixel region. FIGS. 20 to 22 may be diagrams illustrating the pixel PX according to the example implementation illustrated in FIG. 19.

FIGS. 21 and 22 may illustrate cross-sections of portions of a first layer of a pixel region illustrated in FIG. 20. The first layer may include a first substrate SUB, a first interlayer insulating layer IIL, a semiconductor layer SL, and a first insulating layer IL. The pixel region may include a photodiode PD, a floating diffusion region FD, a transfer transistor, an amplification transistor, a selection transistor, a reset transistor, a gain conversion transistor, and a capacitor. Specific example implementations of the pixel region may be similar to those described above with reference to FIGS. 6 to 8.

When FIGS. 20 to 22 are compared with FIGS. 6 to 8, positions at which the gain control transistor and the reset transistor are formed may be different from each other.

Referring to FIGS. 20 and 21, a gate TG of the transfer transistor, the floating diffusion region FD, a gate RG of the reset transistor, and a second node region NR2 may be disposed in a second direction (X-axis direction), parallel to an upper surface of the first substrate SUB and perpendicular to a first direction. The second node region NR2 may be a region in which the first power voltage node of FIG. 19 is formed.

Referring to FIGS. 20 and 22, the semiconductor layer SL may extend in a third direction (Y-axis direction), parallel to the upper surface of the first substrate SUB and perpendicular to the first direction and the second direction. A second direction in which the gate TG of the transfer transistor or the second node region NR2 is disposed may intersect a third direction in which the semiconductor layer SL extends.

In addition, the first node region NR1, a gate DCG of the gain control transistor, the floating diffusion region FD, and a gate SEL of the selection transistor may be disposed in the third direction. The first node region NR1 may be a region in which the first node N1 of FIG. 19 is formed.

At least one of the example implementations illustrated in FIGS. 10 to 18 may be applied to a structure of the pixel region according to the example implementation illustrated in FIGS. 20 to 22.

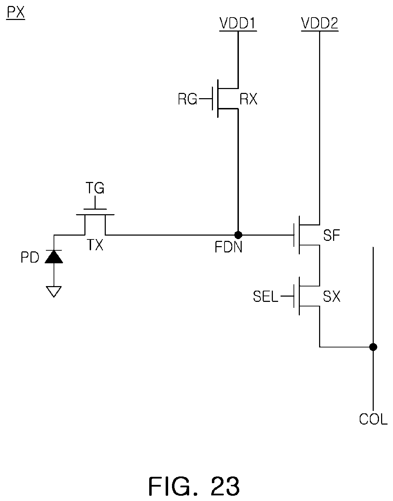

FIG. 23 is a circuit diagram of an example of a pixel included in an image sensor.

Referring to FIG. 23, a pixel PX may include a photodiode PD and a pixel circuit. The pixel circuit may include a floating diffusion node FDN, a transfer transistor TX, a reset transistor RX, an amplification transistor SF, and a selection transistor SX. When FIG. 23 is compared with FIGS. 4 and 19, the pixel PX according to the example implementation illustrated in FIG. 23 may not include a gain control transistor DCX and a capacitor CAP.

Each of a plurality of transistors included in the pixel circuit may include gates TG, RG, and SEL. Control signals for controlling the plurality of transistors included in the pixel circuit may be output by a row driver.

The floating diffusion node FDN may be connected to the photodiode PD through the transfer transistor TX. When the transfer transistor TX is turned on by a transfer control signal, charge of the photodiode PD may be stored in the floating diffusion node FDN.

In the example implementation illustrated in FIG. 23, the reset transistor RX may be connected to a space between (e.g. connected between) a first power node and the floating diffusion node FDN. The first power node may be a node, supplying a first power voltage VDD1, and may be connected to a drain of the reset transistor RX.

The amplification transistor SF may be connected to the floating diffusion node FDN, and the amplification transistor SF may be connected to a space between (e.g. connected between) a second power node and the selection transistor SX. The second power node may be a node, supplying a second power voltage VDD2. In some example implementations, the first power voltage VDD1 may be equal to or different from the second power voltage VDD2.

The amplification transistor SF may operate as a source-follower amplifier, and may generate a signal by amplifying a voltage of the floating diffusion node FDN. The signal, generated by the amplification transistor SF, may be output to a column line COL by a turn-on operation of the selection transistor SX. The column line COL may be connected to one of input terminals of a correlated double sampler, and the correlated double sampler may transmit, to a counter, a signal, output to the column line COL, and an output signal, determined by a ramp voltage.

In some implementations, a source region, a drain region, and a channel region of the amplification transistor SF may be formed in a semiconductor layer. The channel region of the amplification transistor SF may be formed in a portion of the semiconductor layer, disposed on a region in which the floating diffusion node FDN is formed. In other words, a metal interconnection between the floating diffusion node FDN and a gate of the amplification transistor SF may be omitted. Thus, a conversion gain when the gain control transistor DCX is turned off may be further increased.

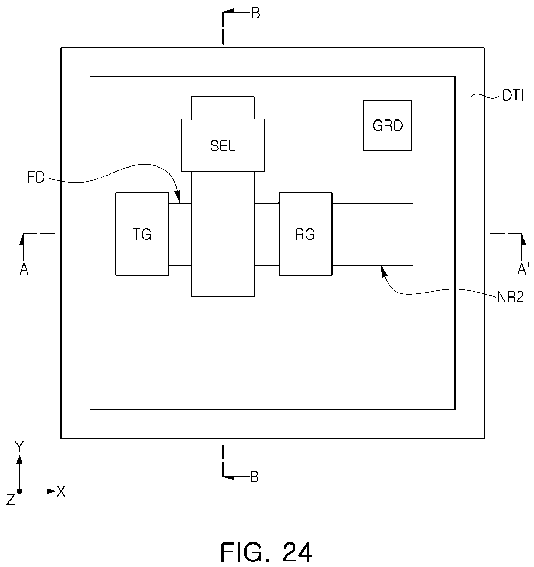

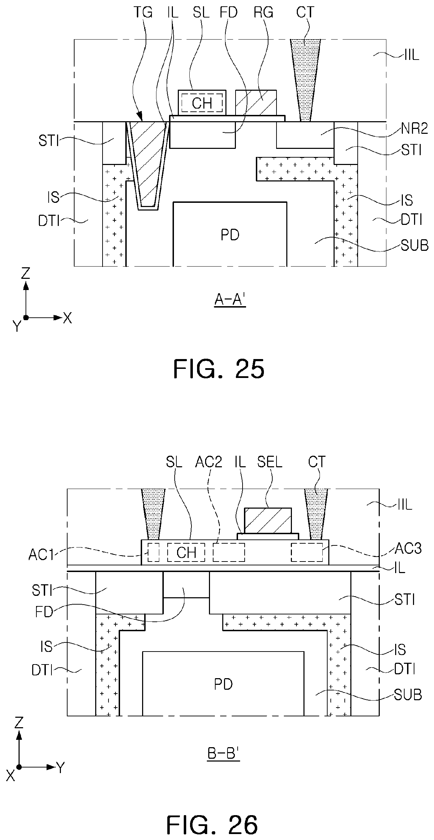

FIG. 24 is a layout diagram illustrating an example of a pixel region. FIG. 25 is a diagram illustrating an example of a portion of a cross-section of the pixel region illustrated in FIG. 24 in direction A-A'. FIG. 26 is a diagram illustrating an example of a portion of a cross-section of the pixel region illustrated in FIG. 24 in direction B-B'.

An image sensor may include a first layer on which a plurality of pixels are formed, and a second layer on which a peripheral circuit is disposed. The peripheral circuit may be connected to the plurality of pixels through a plurality of row lines and a plurality of column lines to drive the plurality of pixels. The first layer and the second layer may be stacked in a first direction (Z-axis direction). Specific example implementations of the image sensor may be similar to those described with reference to FIGS. 1 to 3.

The plurality of pixels may be isolated from each other through a deep trench isolation DTI. In the example implementation illustrated in FIG. 24, one pixel may be formed in a pixel region. FIGS. 24 to 26 may be diagrams illustrating the pixel PX according to the example implementation illustrated in FIG. 23.

FIGS. 25 and 26 may illustrate cross-sections of portions of a first layer of a pixel region illustrated in FIG. 24. The first layer may include a first substrate SUB, a first interlayer insulating layer IIL, a semiconductor layer SL, and a first insulating layer IL. The pixel region may include a photodiode PD, a floating diffusion region FD, a transfer transistor, an amplification transistor, a selection transistor, and a reset transistor. Specific example implementations of the pixel region may be similar to those described above with reference to FIG. 23.

Referring to FIGS. 24 and 25, a gate TG of the transfer transistor, the floating diffusion region FD, a gate RG of the reset transistor, and a second node region NR2 may be disposed in a second direction (X-axis direction), parallel to an upper surface of the first substrate SUB and perpendicular to a first direction. The second node region NR2 may be a region in which the first power voltage node of FIG. 23 is formed.

Referring to FIGS. 24 and 26, the semiconductor layer SL may extend in a third direction (Y-axis direction), parallel to the upper surface of the first substrate SUB and perpendicular to the first direction and the second direction. A second direction in which the gate TG of the transfer transistor or the second node region NR2 is disposed may intersect a third direction in which the semiconductor layer SL extends. In addition, the floating diffusion region FD and the gate SEL of the selection transistor may be disposed in the third direction.

At least one of the example implementations illustrated in FIGS. 24 to 26 may be applied to a structure of the pixel region according to the example implementation illustrated in FIGS. 10 to 18.

According to some implementations, a layer on which a plurality of pixels are formed may include a semiconductor layer, and an active region of an amplification transistor may be formed in the semiconductor layer. Accordingly, a metal interconnection, connecting a floating diffusion region and an amplification transistor to each other, may be omitted, thereby increasing a conversion gain.

Embodiments are set out in the following Clauses:
Clause 1. An image sensor comprising:
   a first layer having a plurality of pixels; and
   a second layer having a peripheral circuit, the peripheral circuit being configured to obtain a pixel signal based on driving the plurality of pixels, and the second layer being stacked on the first layer in a first direction,
   wherein each pixel of the plurality of pixels includes a photodiode, a floating diffusion region configured to store charge generated by the photodiode, a transfer transistor connected with a space between the photodiode and the floating diffusion region, an amplification transistor connected with the floating diffusion region, and a selection transistor connected with a space between the amplification transistor and a column line,
   wherein the first layer includes a first substrate, a first interlayer insulating layer positioned on a surface of the first substrate, a semiconductor layer positioned on a portion of the surface of the first substrate, and a first insulating layer positioned between the first substrate and the semiconductor layer,
   wherein a gate of the transfer transistor and the floating diffusion region are disposed in a second direction, the semiconductor layer extends in a third direction, and the second direction intersects the third direction, and
   wherein the second direction and the third direction are parallel to an upper surface of the first substrate, and the second direction and the third direction are perpendicular to the first direction.
Clause 2. The image sensor of Clause 1, wherein
   each pixel of the plurality of pixels includes a gain control transistor and a capacitor, the gain control transistor being connected with a space between the floating diffusion region and a first node, and the capacitor being connected to the first node, and
   an active region of the gain control transistor is positioned in the first substrate, and the capacitor is positioned on the first insulating layer.
Clause 3. The image sensor of Clause 2, wherein each pixel of the plurality of pixels includes a reset transistor connected with a space between a first power node and the first node.
Clause 4. The image sensor of any preceding Clause, wherein the semiconductor layer includes an amorphous oxide semiconductor, a 2D nanomaterial, amorphous silicon, or polysilicon.
Clause 5. An image sensor comprising:
   a first layer having a plurality of pixels; and
   a second layer having a peripheral circuit, the peripheral circuit being configured to obtain a pixel signal based on driving the plurality of pixels, and the second layer being stacked on the first layer in a first direction,
   wherein each pixel of the pixels includes a photodiode, a floating diffusion region configured to store charge generated by the photodiode, a transfer transistor connected with a space between the photodiode and the floating diffusion region, a reset transistor connected with a space between the floating diffusion region and a first power node, an amplification transistor connected with a space between the floating diffusion region, and a selection transistor connected with a space between the amplification transistor and a column line,
   wherein the first layer includes a first substrate, a first interlayer insulating layer positioned on a surface of the first substrate, a semiconductor layer positioned on a portion of the surface of the first substrate, and a first insulating layer positioned between the first substrate and the semiconductor layer,
   wherein the photodiode, the floating diffusion region, an active region of the transfer transistor, and an active region of the reset transistor are positioned in the first substrate,
   wherein a channel region of the amplification transistor is positioned in a portion of the semiconductor layer disposed on the floating diffusion region, and a gate of the amplification transistor is positioned as the floating diffusion region, and
   wherein a gate of the transfer transistor is a vertical transfer gate, and the photodiode is disposed below the floating diffusion region in the first direction.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While example implementations have been shown and described above, it will be apparent to those skilled in the art that modifications and variations could be made without departing from the scope of the present disclosure as defined by the appended claims.

## Claims

1. An image sensor comprising:
a first layer (L1) having a plurality of pixels; and
a second layer (L2) having a peripheral circuit, the peripheral circuit being connected with the plurality of pixels through a plurality of row lines and a plurality of column lines, the peripheral circuit being configured to drive the plurality of pixels, and the second layer (L2) being stacked on the first layer (L1) in a first direction,
wherein each pixel of the plurality of pixels includes a photodiode (PD), a floating diffusion region (FD) configured to store charge generated by the photodiode (PD), a transfer transistor (TX) connected with a space between the photodiode (PD) and the floating diffusion region (FD), and an amplification transistor (SF) connected with the floating diffusion region,
wherein the first layer (L1) includes a first substrate (SUB), a first interlayer insulating layer (IIL) positioned on a surface of the first substrate (SUB), a semiconductor layer (SL) positioned on a portion of the surface of the first substrate (SUB), and a first insulating layer positioned (IL) between the first substrate (SUB) and the semiconductor layer (SL),
wherein a source region (AC1), a drain region (AC2), and a channel region (CH) of the amplification transistor (SF) are positioned in the semiconductor layer (SL), and
wherein the channel region (CH) of the amplification transistor (SF) is positioned in a portion of the semiconductor layer (SL) overlapping the floating diffusion region (FD) in the first direction.

2. The image sensor of claim 1, wherein a gate of the transfer transistor (TX) is a vertical transfer gate.

3. The image sensor of claim 2, wherein the photodiode (PD) is disposed below the floating diffusion region (FD) in the first direction.

4. The image sensor of any preceding claim, wherein the semiconductor layer (SL) includes an amorphous oxide semiconductor.

5. The image sensor of any of claims 1-3, wherein the semiconductor layer (SL) includes a 2D nanomaterial.

6. The image sensor of any of claims 1-3, wherein the semiconductor layer (SL) includes amorphous silicon or polysilicon.

7. The image sensor of any preceding claim, wherein each pixel of the plurality of pixels includes a selection transistor (SX) connected with a space between the amplification transistor (TX) and a column line (COL).

8. The image sensor of claim 7, wherein a source region (AC2) and a drain region (AC3) of the selection transistor (SX) are positioned in the semiconductor layer (SL), and a gate (SEL) of the selection transistor (SX) is positioned on the semiconductor layer (SL).

9. The image sensor of claim 8, wherein
a lower surface of a first portion of the semiconductor layer (SL) contacts the first insulating layer (IL), and a lower surface of a second portion of the semiconductor layer (SL) contacts the first interlayer insulating layer (IIL), and
the first portion of the semiconductor layer (SL) overlaps the floating diffusion region (FD) in the first direction.

10. The image sensor of claim 7, wherein a source region and a drain region of the selection transistor (SX) are positioned in the first substrate (SUB), and a gate (SEL) of the selection transistor (SX) is positioned on the first insulating layer (IL).

11. The image sensor of any of claims 7-10, wherein
each pixel of the plurality of pixels includes a reset transistor connected with a space between the floating diffusion region (FD) and a first power node,
the amplification transistor (SF) is connected with a space between the floating diffusion region (FD) and a second power node, and
a source region and a drain region of the reset transistor (RX) are positioned in the first substrate (SUB), and a gate (SEL) of the selection transistor (SX) is positioned on the first insulating layer (IL).

12. The image sensor of claim 11, wherein
each pixel of the plurality of pixels includes a gain control transistor (DCX) and a capacitor (CAP), the gain control transistor (DCX) being connected with a space between the floating diffusion region (FD) and a first node (N1), and the capacitor (CAP) being connected with the first node (N1), and
a gate (DCG) of the gain control transistor (DCX) and the capacitor are positioned on the first insulating layer (IL), and the gate (DCG) of the gain control transistor (DCX) is adjacent to the semiconductor layer (SL).

13. The image sensor of claim 12, wherein the reset transistor (RX) is connected with a space between the first power node and the first node (N1).

14. The image sensor of any preceding claim, wherein
each pixel of the plurality of pixels includes a back gate (BG) configured to receive a negative voltage,
the back gate (BG) overlaps the floating diffusion region (FD) and a portion of the semiconductor layer (SL) in the first direction, and
the portion of the semiconductor layer (SL) includes the channel region (CH) of the amplification transistor (SF).

15. The image sensor of any preceding claim, wherein a portion of the semiconductor layer (SL), adjacent to the floating diffusion region (FD), has a fin structure.
